# EUROPEAN PATENT APPLICATION

(11) **EP 1 263 038 A2**
(43) Date of publication of application: **04.12.2002**
(21) Application number: 02253816.9
(22) Date of filing: 30.05.2002
(51) Int. Cl.: H01L 23/00, H01L 25/00

(54) **Electronic component and mobile communication device using such electronic component**

(30) Priority: 31.05.2001 JP 2001165880
(71) Applicant: NGK SPARK PLUG CO., LTD, Mizuho-ku Nagoya-shi Aichi (JP)
(72) Inventor: Yoshida, Yoshitaka, NGK Spark Plug Co., Ltd, Nagoya, Aichi (JP); Nasu, Takakuni, NGK Spark Plug Co., Ltd, Nagoya, Aichi (JP); Sakurai, Tomoaki, NGK Spark Plug Co., Ltd, Nagoya, Aichi (JP); Kato, Daisuke, NGK Spark Plug Co., Ltd, Nagoya, Aichi (JP); Yoshikawa Hajime, NGK Spark Plug Co., Ltd, Nagoya, Aichi (JP)
(74) Representative: Brown, Kenneth Richard

(57) **Abstract**

Problem

The present invention provides an electronic component for use in a mobile communication apparatus and improved in joining strength to a print substrate, and also provides the mobile communication apparatus using this electronic part.

Solution

In an electronic part formed by laminating first and second insulator substrates, an auxiliary electrode 8 is arranged in at least a portion of the laminating layer face on one side of the second insulator substrate in a portion of that laminating layer face which does not overlap the corresponding laminating layer face of the first insulator substrate.

## Description

### BACKGROUND OF THE INVENTION

### Field of the Invention

The present invention relates to an electronic component such as an antenna switch module, a coupler, a diplexer, a duplexer, a filter, etc. for use in a mobile communication apparatus (a portable telephone, a simple type portable telephone, etc.).

### Prior Art

In recent years, a mobile communication apparatus such as a portable telephone and a simple type portable telephone (a so-called PHS) has been made remarkably light and compact. The need for compactness of electronic components used in mobile communication apparatus has correspondingly increased. For example, one of the electronic components used in the mobile communication apparatus is an antenna switch module for switching an antenna between signal transmission and signal reception (see, for example, Japanese Patent Laid-Open No. 2001-127663, etc.).

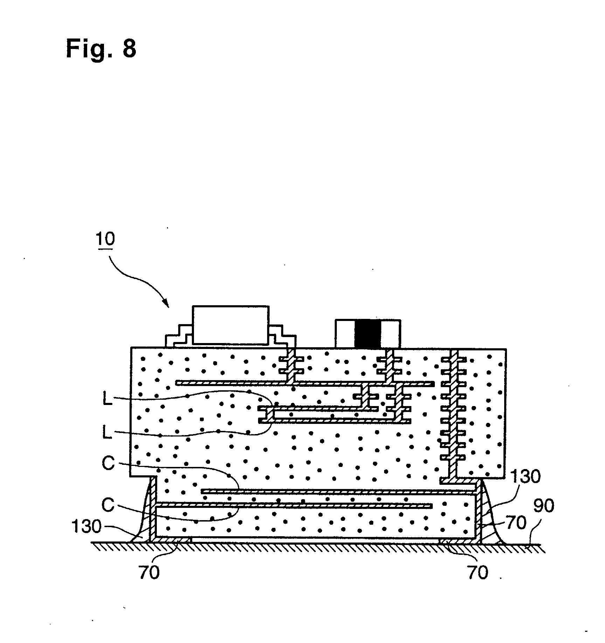

To attach the antenna switch module to a print substrate, surface mounting was conventionally performed using solder (a solder fillet) provided between an external terminal of the module and a pad portion of the print substrate. For example, in an antenna switch module 10 disclosed in Japanese Patent Laid-Open No. 2001-127663, as shown in Fig. 8, an external terminal 70 formed on a side face and a bottom face of the component and an unillustrated conductor of a print substrate 90 are joined to each other by a solder fillet 130 and surface mounting is performed.

However, as the electronic component itself is made more compact, the area of the external terminal provided on the electronic component, i.e., the area of a portion used in the joining is correspondingly reduced. Therefore, it eventually becomes impossible to obtain sufficient strength in the joint between the solder (solder fillet 130) and the external terminal of the electronic part. More particularly, when the print substrate mounting the antenna switch module thereto is dropped, a problem arises in that the antenna switch module may in some cases fall off from the print substrate by the resulting impact, etc. applied in the dropping.

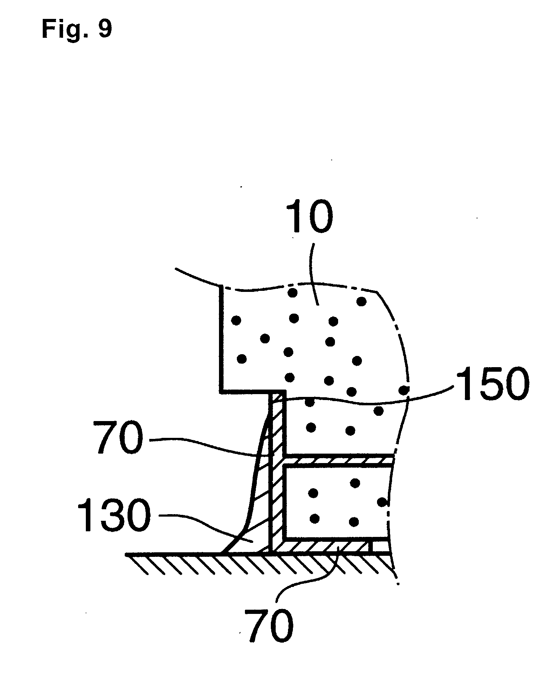

Further, as shown in Fig. 9, when the antenna switch module comprising first (lower) and second (upper) insulator substrates is mounted to the print substrate, a clearance 150 is formed between the solder fillet 130 and the second insulator substrate since no solder fillet 130 is joined to the second insulator substrate. Therefore, when an external force is applied to the antenna switch module by the impact such as dropping, etc., stress is concentrated onto a laminating layer interface between the first and second insulator substrates so that a crack is formed in a laminating layer body. Therefore, a problem also exists in that there is a possibility that a circuit within the laminating layer body becomes short-circuited or disconnected.

### SUMMARY OF THE INVENTION

In view of the above problems, an object of the present invention is to provide an electronic component for use in a mobile communication apparatus and adapted for improved strength in its joint to a print substrate, and also to provide a mobile communication apparatus using such an electronic component.

In one aspect, the present invention provides an electronic component comprising at least first and second insulator substrates laminated one on another in a laminating direction; wherein an external terminal is provided on an edge face of the first insulator substrate extending in the laminating direction, and an auxiliary electrode is provided in at least one portion of a laminating face on a side of the second insulator substrate in a portion of said laminating face which does not overlap the corresponding laminating face of the first insulator substrate. The laminating face as referred to above does not mean only a contact portion between the laminated first and second insulator substrates, but means the entire surface on the second (first) insulator substrate side of the first (second) insulator substrate.

Accordingly, the area of a portion available for joining to solder is increased so that the joining strength of the electronic component is improved.

The insulator substrate as defined in the present invention is also referred to herein as an insulating layer. Further, the electronic component in the present invention is particularly a mounting type electronic component to be mounted to a print substrate, etc.

In the electronic component of the present invention a concave recess is preferably formed on the side face of the first insulator substrate, and the external terminal is formed in the concave recess.

In this way, it is not necessary to provide extra space for accommodating the auxiliary electrode on the second insulator substrate. Therefore, there is no increase in size of the second insulator substrate or consequently, of the entire electronic component, and the joining strength to the print substrate can be improved. Further, it is not necessary to reduce the first insulator substrate in size so as to provide the extra space for accommodating the auxiliary electrode on the second insulator substrate. As a result, it is not necessary, from the point of view of ensuring proper attachment to the print substrate, to change an existing wiring conductor pattern on the print substrate to correspond with a change in the size of the first insulator substrate; the time taken in the design stage can thus be reduced.

The electronic component is suitable for mounting to a print substrate by using solder. In the mounting process, a solder fillet is wetted and spreads to both the external terminal and the auxiliary electrode and is thereby joined to both the first and second insulator substrates; the joining strength to the print substrate can thus be improved.

Preferably, the auxiliary electrode and the external terminal are connected to each other on the surface of a laminating layer body formed from the first and second insulator substrates.

In this way an end face of the laminating layer face of the first insulator substrate is covered with the solder fillet. Accordingly, stress is not concentrated onto the laminating layer interface between the first and second insulator substrates. This avoids the generation of a crack and any resulting short-circuiting in a circuit formed within the laminating layer body.

Preferably, the first and second insulator substrates are constructed by glass ceramic formed by a ceramic component and a glass component.

Accordingly, a low resistance metal such as Cu, Ag, etc. can be used as materials for the capacitor, the inductor, the external terminal and the auxiliary electrode. Therefore, the electronic component has excellent high frequency characteristics. Further, since glass ceramic normally has a low burning temperature such as about 1000°C or less, the burning temperature required during the manufacturing process can be reduced in comparison with that required when using a ceramic formed by alumina.

Preferably, the auxiliary electrode is formed in only an edge end portion of the laminating layer face on the side of the second insulator substrate.

Accordingly, it is possible to avoid unwanted connection to a circuit pattern (a capacitor and an inductor) formed within the laminating layer body, and also to restrain parasitic inductance of the auxiliary electrode itself.

Preferably, at least one of a capacitor electrode constituting a capacitor and an inductor electrode constituting an inductor is provided, and said capacitor electrode and said inductor electrode are formed within, or on the surfaces of, said first and second insulator substrates.

Thus, the entire electronic component can be made compact and in particular can be reduced in height in comparison with a case in which the capacitor and the inductor are mounted as a chip part to the laminating layer body constituting the electronic component.

Preferably, the electronic component includes: a diplexer comprising at least a capacitor and an inductor; a high frequency switch comprising at least a semiconductor element and an inductor; and a filter comprising at least a capacitor and an inductor; said semiconductor element of said high frequency switch being mounted on the second insulator substrate; and an inductor electrode constituting the inductor of said high frequency switch, an inductor electrode constituting the inductor of said diplexer and a capacitor electrode constituting the capacitor of said diplexer, and an inductor electrode constituting the inductor of said filter and a capacitor electrode constituting the capacitor of said filter being formed within, or on the surfaces of, said first and second insulator substrates.

Thus, the electronic component itself can be made compact by arranging the capacitor and the inductor to be internally layered and a diode constituting the semiconductor element to be mounted to the laminating layer body. Further, even when the diode is mounted and the electronic component itself is increased in weight, the strength of the joint between the electronic component and the print substrate is improved since the area of a portion joined to the solder relative to the entire electronic component is increased.

In another aspect, the present invention provides a mobile communication device including the above electronic component.

In such a mobile communication device, since the electronic component having improved strength in its joint to the print substrate is used, the overall mechanical and electric reliability is improved, particularly with respect to its resistance to failure due to external shock such as by dropping of the mobile communication device, etc.

### BRIEF DESCRIPTION OF THE DRAWINGS

Fig. 1 is a sectional view of an antenna switch module (electronic component) in accordance with the present invention when mounted to a print substrate;
Fig. 2 is an enlarged sectional view of an external terminal portion when the antenna switch module (electronic component) of Fig. 1 is mounted to a print substrate;
Fig. 3 is a block diagram schematically showing the circuit structure of an antenna switch module for use in a mobile communication device;
Fig. 4 is a circuit diagram showing in more detail the construction of the antenna switch module (electronic component) of Fig. 3 for use in a mobile communication device;
Fig. 5 is an exploded perspective view of part of a laminating layer body constituting an antenna switch module (electronic component) in accordance with the present invention;
Fig. 6 is an underneath side perspective view of an antenna switch module (electronic component) in accordance with the present invention;
Fig. 7 is a top plan perspective view of the antenna switch module (electronic component) of Fig. 6;
Fig. 8 is a sectional view of a conventional antenna switch module when mounted time to a print substrate; and
Fig. 9 is an enlarged sectional view of an external terminal portion of a conventional antenna switch module of Fig. 8 when mounted to the print substrate.

### DESCRIPTION OF THE PREFERRED EMBODIMENTS

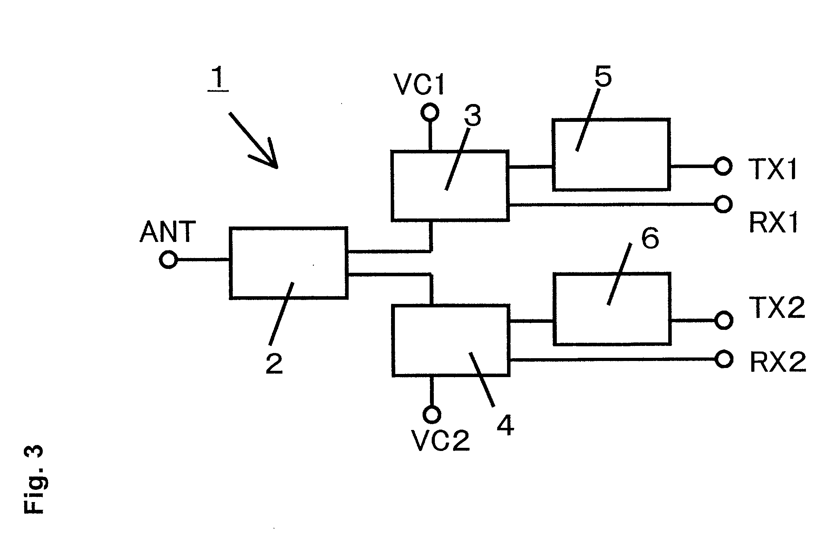

The embodiments of the present invention will next be described with reference to the drawings. An antenna switch module 1 is given as one example of an electronic component of the present invention. The antenna switch module 1 is formed of a diplexer 2, first and second high frequency switches 3, 4 and first and second filters 5, 6, as shown in the block diagram of Fig. 3. The antenna switch module 1 has a transmitting terminal TX1 connected to a GSM (900 MHz band) transmitting section, a transmitting terminal TX2 connected to a DCS (1.8 GHz band) transmitting section, a receiving terminal RX1 connected to a GSM receiving section, a receiving terminal RX2 connected to a DCS receiving section, an antenna terminal ANT connected to an antenna, control terminals VC1, VC2 connected to a control section, and a ground terminal GND connected to a reference electric potential of a wireless section.

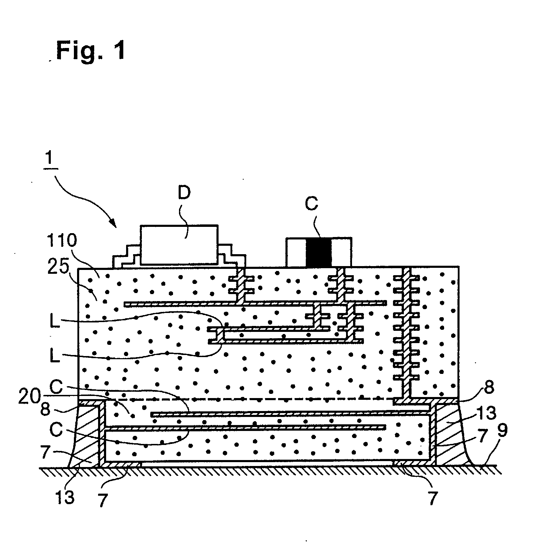

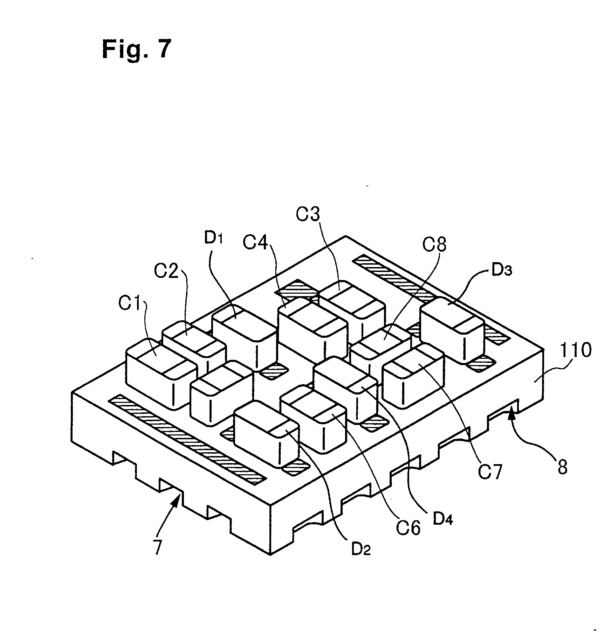

As shown in Figs. 1 and 7, the antenna switch module 1 is formed of a laminating layer body 110 in which a plurality of insulating layers (insulator substrates) are laminated. The insulating layers (insulator substrates) constituting the laminating layer body include an insulating layer having an external terminal 7 on its side face. Amongst the elements constituting the antenna switch module, the diplexer 2 and the filters 5, 6 are respectively constructed by an inductor L and a capacitor C. The diplexer 2 and the filters 5, 6 are respectively formed by an electrode pattern of a predetermined shape on the insulating layer, and are internally layered in the laminating layer body.

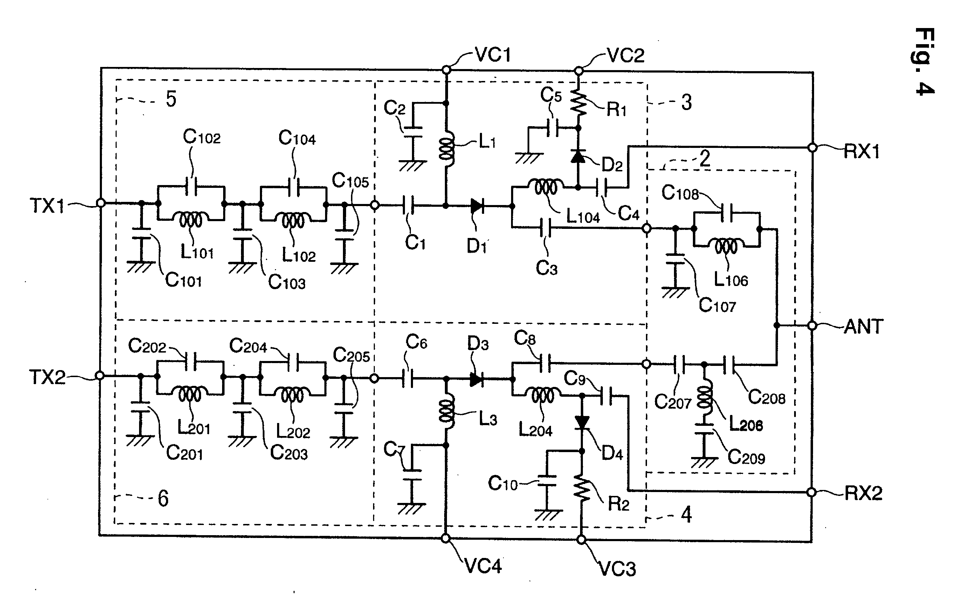

As shown in Fig. 4, the diplexer is constructed by combining a low pass filter and a high pass filter, and is formed by capacitors C107, C108, C207, C208, C209 and inductors L106, L206. The diplexer is connected between a high frequency switch and an antenna terminal.

As also shown in Fig. 4, the filter 5 is formed by capacitors C101, C102, C103, C104, C105 and inductors L101, L102, and constitutes the low pass filter in this embodiment.

As also shown in Fig. 4, the filter 6 is formed by capacitors C201, C202, C203, C204, C205 and inductors L201, L202, and constitutes the low pass filter in this embodiment. The filter 6 is similar to the above filter 5 except for a difference in the pass band.

As also shown in Fig. 4, the high frequency switch 3 has a function for switching between a signal path for outputting a transmitting signal (GSM) passing through the filter 5 to the antenna terminal ANT, and a signal path for inputting a receiving signal received from the antenna to the GSM receiving section. This high frequency switch is formed by capacitors C1, C2, C3, C4, C5, a choke coil L1, an inductor L104, a resistor R1 and diodes D1, D2.

As also shown in Fig. 4, the high frequency switch 4 has a function for switching between a signal path for outputting a transmitting signal (DCS) passing through the filter 6 to the antenna terminal ANT, and a signal path for inputting the receiving signal received from the antenna to the DCS receiving section. This high frequency switch is formed by capacitors C6, C7, C8, C9, C10, a choke coil L3, an inductor L204, a resistor R2 and diodes D3, D4.

In the antenna switch module of this embodiment, diodes D1, D2, D3, D4 of the high frequency switches are mounted onto the laminating layer body 110 as shown in Fig. 7. Capacitors C101, C102, C103, C104, C105, C107, C108, C201, C202, C203, C204, C205, C207, C208, C209 and inductors L101, L102, L104, L106, L201, L202, L204, L206, L1, L3 are respectively formed on the insulating layer in a predetermined electrode pattern, and are built in the laminating layer body 110 (5.4 mm in length, 4.0 mm in width and 0.9 mm in height). Capacitors C1, C2, C3, C4, C6, C7, C8, C9 are mounted onto the laminating layer body 110.

A metallic cap is attached so as to cover an uppermost surface of the laminating layer body 110 so as to provide a shield effect although this metallic cap is not shown in Figs. 1 and 7.

Thus, all of the capacitors and the inductors of the diplexer 2, the filters 5, 6 and the high frequency switches 3, 4 constituting the antenna switch module do not have to be internally layered in the laminating layer body. Similarly to the diodes, components such as a capacitor of large capacitance, an inductor of large inductance, etc. unsuitable for the internal layering in the laminating layer body may be also mounted on the laminating layer body as chip parts.

The insulating layer (insulator substrate) is formed of glass ceramic comprising borosilicate glass and alumina. On the other hand, the electrode pattern is formed by plating an Ag alloy with Ni-Au.

The antenna switch module 1 is mounted to the print substrate by using the transmitting terminals TX1, TX2, the receiving terminals RX1, RX2, the antenna terminal ANT, the control terminals VC1, VC2, the external terminal 7 of the ground terminal GND formed on the surface of the laminating layer body and an auxiliary electrode 8, and attaching these members to wiring in a predetermined position on the print substrate 9 by solder.

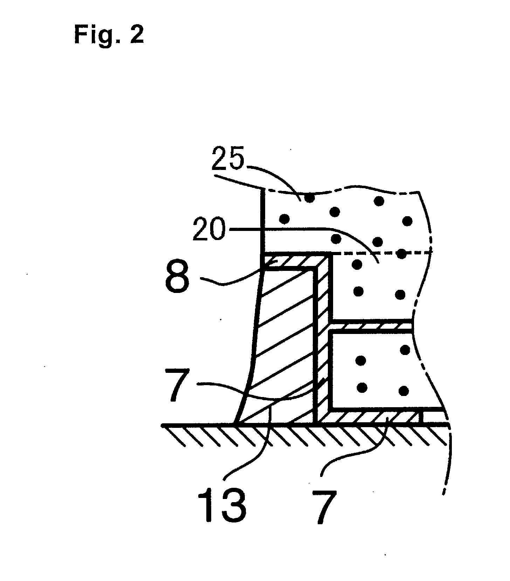

Figs. 1 and 2 show a state in which the antenna switch module is attached to the print substrate. A solder fillet 13 is joined to the external terminal 7 arranged in a first insulating layer (insulator substrate 20), to the auxiliary electrode 8 arranged in a second insulating layer (insulator substrate 25), and to an unillustrated wiring (pad) of the print substrate.

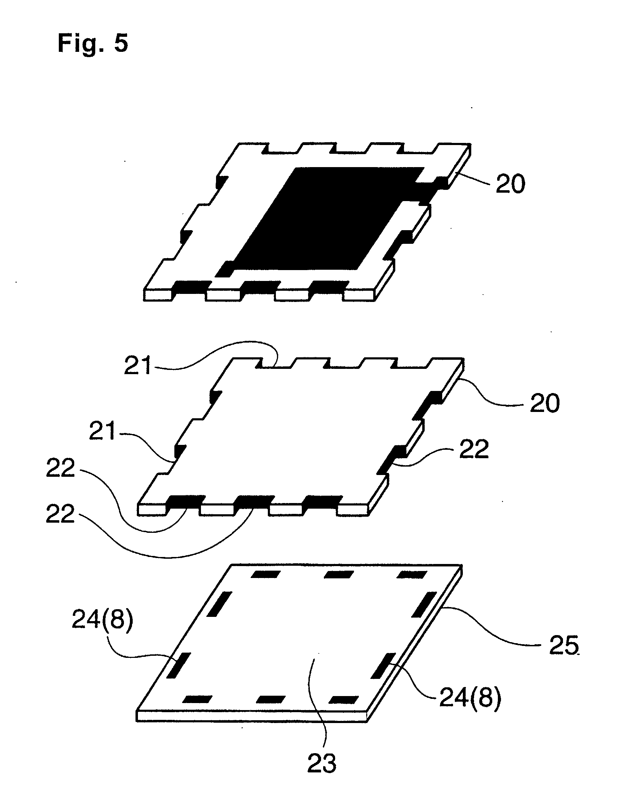

Fig. 5 is a schematic view for explaining the external terminal 7 and the auxiliary electrode 8 arranged in the electronic component of the present invention. As shown in Fig. 5, the external terminal 7 is formed in a concave groove, or recess, 21 (castellation) on a side face of the insulating layer (insulator substrate) 20, and a side face metallizing layer 22 is formed in the castellation. The side face metallizing layer 22 is formed by plating an Ag alloy with Ni-Au. The side face metallizing layer 22 is not limited to the above material, but may be formed by any suitable known material. For example, the side face metallizing layer 22 may be also formed by plating a conductor surface constructed by Ag, Cu, a Cu alloy, etc. with Ni, Ni-P, Ni-boron and a Ni-Au alloy.

As shown in Fig. 5, the auxiliary electrode 8 is formed by a surface metallizing layer 24 on a laminating layer face 23 of the second insulating layer (insulator substrate) 25, lying on a print substrate side in the antenna switch module shown in Fig. 1. Similarly to the above side face metallizing layer 22, the surface metallizing layer 24 can be formed by a suitable known material in a method such as screen printing, etc.

It is not necessary to form the auxiliary electrode 8 on the entire laminating layer face 23 of the second insulating layer (insulator substrate) 25. The auxiliary electrode 8 is preferably formed only at an edge portion of the second insulating layer (insulator substrate), where the second insulator substrate does not overlap but overhangs the first insulator substrate 20 at the positions of the castellations 21.

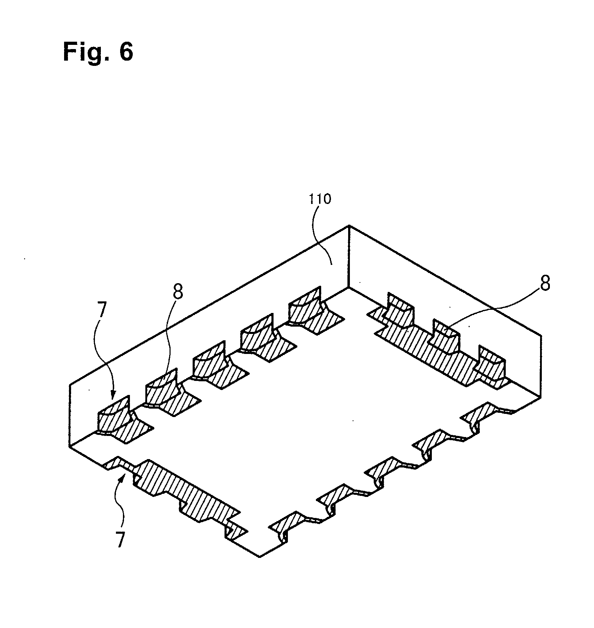

As shown in Fig. 6, external terminals 7 are formed along one side face of the insulating layer (insulator substrate) 20, and external terminals 7 of the same number are also formed along an opposed side face of the insulating layer (insulator substrate) 20. Therefore, joining to the print substrate is strengthened.

Each external terminal 7 and the corresponding auxiliary electrode 8 are formed on the laminating layer body surface in such a way that they are continuously connected to each other. Thus, solder forms a solder fillet such that the solder is wetted to and spreads across both the external terminal and the auxiliary electrode. No clearance is formed between the second insulating layer (insulator substrate) and the solder fillet. Further, an edge portion of the laminating layer face at the sides of the first insulating layer (insulator substrate) is also covered with the solder fillet.

As shown in Fig. 6, the auxiliary electrode 8 is formed on the entire part of laminating layer face 23 at the side of the second insulator substrate 25 in the non-overlapping portion of the first and second insulator substrates.

The area of the non-overlapping portion of the first and second insulating layers (insulator substrates) at each external terminal is set to 0.09 mm². In this embodiment, there are sixteen external terminals in total; these are the transmitting terminal TX1 connected to the GSM (900 MHz band) transmitting section, the transmitting terminal TX2 connected to the DCS (1.8 GHz band) transmitting section, the receiving terminal RX1 connected to the GSM receiving section, the receiving terminal RX2 connected to the DCS receiving section, the antenna terminal ANT connected to the antenna, the control terminals VC1, VC2 connected to the control section, and nine ground terminals GNDs connected to the reference electric potential of the wireless section. The area of the non-overlapping portion of both the insulating layers (insulator substrates) is thus set to 1.44 mm² in total.

The above surface metallizing layer is preferably formed in 60 % or more of the area of the non-overlapping portion of the first and second insulating layers (insulator substrates) at each external terminal. In the case of 60 % or less, the solder fillet is not sufficiently raised and no improvement in joint strength is obtained.

Further, the auxiliary electrode is preferably formed in 4 % or more of the laminating layer face of the second insulating layer (insulator substrate). In the case of 4 % or less, sufficient joining strength to the print substrate is not obtained.

The first and second insulating layers (insulator substrates) 20 are constructed from glass ceramic (low temperature burning ceramic) materials. When these materials are used, the electronic component can be formed by simultaneous burning. Further, various kinds of ceramic such as alumina, aluminum nitride, mullite, etc., resin, or a composite material of ceramic and resin can be used as other materials for the first and second insulating layers (insulator substrates) 20. The first insulating layer (insulator substrate) and the second insulating layer (insulator substrate) need not necessarily be constructed from the same material, but may be constructed by combining the above materials.

In this embodiment, the antenna switch module is shown as an example of the electronic component, but the electronic component is not limited to such antenna switch module. The present invention can be applied to any electronic component if this electronic component is one which is to be mounted to a print substrate.

Both an electronic component in accordance with the present invention and an electronic component having no auxiliary electrode were attached to a test jig and a dropping test was performed so as to confirm the effect of the present invention. In the dropping test, the antenna switch module having the auxiliary electrode and the antenna switch module having no such auxiliary electrode were used as the electronic part, and both antenna switch modules were soldered to a jig (108x44x25 mm in size and 100g in weight) for the dropping test. This jig for the dropping test was freely dropped on to an iron plate an arbitrary number of times from a height of 180 cm.

**Table 1**

| | Number of times of Dropping | | |
|---|---|---|---|
| | 6 | 12 | 18 |
| Auxiliary electrode present | ○ | ○ | ○ |
| No auxiliary electrode present | ○ | Δ | x |

O: No detachment of module from the jig resulting from the dropping test.

Δ: No detachment of module from the jig resulting from the dropping test, but a crack is formed in the substrate.

×: Detachment of the module from the jig resulting from the dropping test.

As a result, even when this jig was repeatedly dropped several times, the electronic component of the present invention did not fall off the jig as a result of the dropping test. However, the electronic component having no auxiliary electrode did fall off the jig as a result of the dropping test in a certain case. Further, the laminating layer face portions of both electronic components were examined for cracks after the dropping test. As a result, a crack was seen to have been formed on the laminating face of the electronic component having no auxiliary electrode, but no such formation of the crack was seen in the electronic component of the present invention.

Further, a three-point bending test was performed on the antenna switch module having the auxiliary electrode as the electronic component of the present invention and the antenna switch module having no auxiliary electrode. A sample used in the three-point bending test was made by joining the antenna switch module onto a print substrate (manufactured using glass epoxy resin (FR-4) having an outer shape size of 0.8 mm in thickness, 30 mm in length and 38 mm in width). This sample was supported by left-hand and right-hand support bars (4 mmφ in diameter), and was pressed against a pressing bar (4 mmφ in diameter) arranged above at an intermediate position between the support bars, and its pressure was read by a load cell. The distance between the two support bars was set to 28 mm, and the pressing bar was raised and lowered at a speed of 5 mm/min.

Five samples (sample 1) each formed by connecting the auxiliary electrodes to all external terminals, five samples (sample 2) each formed without connecting the auxiliary electrodes and the external terminals, five samples (sample 3) each formed by connecting the auxiliary electrode to only one of the external terminals, and five samples (sample 4) each having no auxiliary electrode were used.

In performing a judgment of measured parameters at a breaking time, a load curve was recorded by a recorder, and the time point at which a ripple was generated in the curve was taken as the breaking point.

**Table 2**

| Sample No. | Flexing amount (mm) | Breaking load (N) |
|---|---|---|
| 1 | 0.93 | 63.5 |
| 2 | 0.84 | 58.3 |
| 3 | 0.89 | 60.4 |
| 4 | 0.8 | 55.1 |
| Each value is an average value. | | |

Table 2 shows a breaking load with respect to a flexing amount. In accordance with the results of this Table 2, the flexing amount is 0.80 mm and the breaking load is 55.1 N in average value in the sample 4 (conventional product). In contrast to this, in the sample 1 (the product according to the present invention), the flexing amount is 0.93 mm and the breaking load is 63.5 N in average values. Accordingly, in comparison with the conventional product, the flexing amount and the breaking load are respectively improved by 16 % and 15 %. In the sample 2, the flexing amount is 0.84 mm and the breaking load is 58.3 N in average values. In the sample 3, the flexing amount is 0.89 mm and the breaking load is 60.4 N in average values. It has been found from these results that the mounting type electronic component of the present invention having the auxiliary electrode is strong in withstanding the bending load as compared with the conventional mounting type electronic component having no auxiliary electrode. Further, it has been also found preferable to provide the auxiliary electrode in all of the external terminals, and connected thereto.

## Claims

1. An electronic component comprising at least first and second insulator substrates (20, 25) laminated one on another in a laminating direction; wherein
an external terminal (7) is provided on an edge face of said first insulator substrate (20) extending in the laminating direction, and
an auxiliary electrode (8) is provided in at least one portion of a laminating face (23) on a side of the second insulator substrate (25) in a portion of said laminating face which does not overlap the corresponding laminating face of said first insulator substrate.

2. An electronic component according to claim 1, wherein a concave recess (21) is formed on said side face of said first insulator substrate, and said external terminal (7) is formed in the concave recess.

3. An electronic component according to claim 1 or claim 2, wherein
said auxiliary electrode (8) and said external terminal (7) are connected to each other on the surface of a laminating layer body formed from said first and second insulator substrates.

4. An electronic component according to claim 1 or claim 3, wherein
said auxiliary electrode is formed in only an edge portion of the laminating layer face (23) on one side of said second insulator substrate.

5. An electronic component according to any of claims 1 to 4, wherein
at least one of a capacitor electrode constituting a capacitor (C) and an inductor electrode constituting an inductor (L) is provided, and
said capacitor electrode and said inductor electrode are formed within, or on the surfaces of, said first and second insulator substrates.

6. An electronic component according to any of claims 1 to 5, wherein
the electronic component includes:
a diplexer (2) comprising at least a capacitor (C107/108, C207-209) and an inductor (L106/206);
a high frequency switch (3, 4) comprising at least a semiconductor element (D1, D2) and an inductor (L104); and
a filter (6) comprising at least a capacitor (C201-205) and an inductor (L201/202);
said semiconductor element of said high frequency switch is mounted on said second insulator substrate; and
an inductor electrode constituting the inductor of said high frequency switch, an inductor electrode constituting the inductor of said diplexer and a capacitor electrode constituting the capacitor of said diplexer, and an inductor electrode constituting the inductor of said filter and a capacitor electrode constituting the capacitor of said filter, are formed within or on the surfaces of said first and second insulator substrates.

7. An electronic component according to any of claims 1 to 6, wherein
said first and second insulator substrates are formed of glass ceramic.

8. A mobile communication device **characterized in that** the mobile communication device includes an electronic component according to any preceding claim.

9. A mobile communication device according to claim 8, further comprising a mounting substrate having a conductive wiring portion formed thereon, the electronic component being mounted on said mounting substrate with said conductive wiring portion being electrically connected to both said external terminal and said auxiliary electrode by means of a solder fillet which contacts said conductive wiring portion, said external terminal and said auxiliary electrode.

10. A mobile communication device according to claim 9, the electronic component being as claimed in claim 2 or any claim dependent thereon, wherein the solder fillet occupies said concave recess.
